# EUROPEAN PATENT SPECIFICATION

(11) **EP 0 385 689 B1**
(45) Date of publication and mention of the grant of the patent: **01.02.1995**
(21) Application number: 90302007.1
(22) Date of filing: 26.02.1990
(51) Int. Cl.: H05K 1/02, H05K 1/00, H05K 9/00

(54) **Printed circuit board capable of preventing electromagnetic interference**
Leiterplatte, geeignet zur Vermeidung elektromagnetischer Interferenzen
Plaque de circuit imprimé capable d'éviter des interférences électromagnétiques

(30) Priority: 27.02.1989 JP 21878/89
(43) Date of publication of application: 05.09.1990
(73) Proprietor: NINTENDO CO. LIMITED, Higashiyama-ku Kyoto (JP)
(72) Inventor: Nakagawa, Katsuya, c/o Nintendo Co., Ltd., Higashiyama-ku, Kyoto (JP); Nagano, Masakazu, c/o Nintendo Co., Ltd., Higashiyama-ku, Kyoto (JP); Higashiyama, Jun, c/o Nintendo Co., Ltd., Higashiyama-ku, Kyoto (JP)
(74) Representative: Read, Matthew Charles

(56) References cited:
- EP-A- 0 238 267
- EP-A- 0 259 785
- EP-A- 0 384 644
- DE-A- 1 936 899
- FR-A- 2 527 039
- IBM TECHNICAL DISCLOSURE BULLETIN, vol. 30, no. 4, September 1987, page 1558,Armonk, New York, US; "Method to form an electromagnetic shield on a component-populated electronic circuit board"

## Description

### Field of the invention

The present invention relates to a printed circuit board capable of preventing electromagnetic interference. More specifically, the present invention relates to a printed circuit board capable of preventing electromagnetic interference comprising a first electric conductive layer which forms a signal pattern and a ground pattern, an insulation layer covering the first conductive layer, and a second electric conductive layer formed on the insulation layer to be connected to the ground pattern.

### Description of the prior art

Recently, a digital IC such as a microcomputer, and microprocessor. becomes to be used for a various electronic equipments as well as a personal computer, and video game machine. In a case where such a digital IC is mounted on a printed circuit board, the printed circuit board itself becomes a radiation source, and therefore, an electromagnetic interference (EMI) noise is radiated in the air (a) from the printed circuit board itself or (b) through an antenna which is formed by a cord or cable connected to the printed circuit board. If it is neglected to reduce the EMI noise, the EMI noise functions as an interference radio wave to the other electronic equipments, that is, the EMI noise causes a reception noise of a television receiver or a malfunction in the various control equipments. Therefore, the EMI noise must be reduced as much as possible.

Conventionally, with respect to the above described cause (a), a shielding technique is utilized. For example, a printed circuit board is covered by a shield plate such as a metal plate, expanded metal or the like which is connected to the ground so as to pass the EMI noise to the ground therethrough, whereby the EMI noise can be prevented from being radiated outside. In addition, with respect to the above described cause (b), a connector which incorporates a specific capacitor is utilized for connecting the cord or cable. However, in any prior arts, it is not possible to completely prevent the EMI noise.

In addition, for example, in Japanese Utility Model Publication No. 55-29276, one example of a method for shielding is disclosed, wherein a silver paste is formed on the base plate to shield the base plate. However, this method is merely a modification of the above described shielding technique and directed to reduce a spurious noise rather than the EMI noise. Such a spurious noise has low-frequency components less than 10 MHz and is regularly generated. Therefore, the method disclosed in Japanese Utility Model Publication No. 55-29276 is effective for the spurious noise but not effective for the EMI noise from the digital IC, which has very high-frequency components of 30-1000 MHz and is generated irregularly. Furthermore, the method disclosed in Japanese Utility Model Publication No. 55-29276 can not deal with the connection of the cord or cable.

Therefore, the inventors has proposed a novel printed circuit board capable of preventing EMI in accordance with a novel idea in Japanese Patent Laid-open No. 62-213192 corresponding to United States Patent No. 4,801,489 (and EP-A-0 238 267). The printed circuit board capable of preventing the EMI includes an insulation layer formed on an insulating base plate so as to cover a first electric conductive layer formed on the insulating base plate, and a second electric conductive layer is further formed on the insulation layer by means of printing of a copper ink or paste and directly surface-connected to a ground pattern provided by said first electric conductive layer. The proposed printed circuit board is effective in some cases, but it is desired to further improve an EMI noise preventing function of a printed circuit board.

### SUMMARY OF THE INVENTION

Therefore, a principal object of the present invention is to provide an improved printed circuit board capable of preventing electromagnetic interference, which can effectively reduce the electromagnetic interference noise.

One aspect in accordance with the present invention is a printed circuit board according to claim 1, capable of preventing electromagnetic interference which comprises an insulating base plate; a first electric conductive layer formed on the insulating base plate, said first electric conductive layer forming a signal pattern and a ground pattern for physical connection to terminals of a digital IC to be received on the board.

A second aspect in accordance with the present invention is a printed circuit board according to claim 5, capable of preventing electromagnetic interference which comprises an insulating base plate; a first electric conductive layer formed on the insulating base plate, said first electric conductive layer forming a signal pattern and a ground pattern for connection to a digital IC to be received on the board.

A third aspect in accordance with the present invention is a printed circuit board according to claim 8, capable of preventing electromagnetic interference which comprises an insulating base plate for receiving connector.

Since the large area ground land is directly surface-connected to the second electric conductive layer, the ground impedance of the ground land, that is, the ground terminal of the digital IC connected thereto becomes minimum. In the conventional printed circuit board, since a ground pattern was formed without any specific consideration, the ground pattern itself has an inductance component, and therefore, the ground pattern did not become an ideal ground with respect to the EMI noise having a high-frequency components of 30-1000 MHz, and thus, there was a case where a weak or small induction energy is generated by a flow of a wide variety of high-frequency currents. By contrast, in the present invention, since the ground impedance is made minimum by the ground land directly surface-connected to the second electric conductive layer, no induction energy is generated, and therefore, the EMI noise due to the induction energy can be effectively suppressed.

In addition, since the large area power source land and the second electric conductive layer are opposite to each other so as to sandwich the insulation layer, an electrostatic capacitance can be formed therebetween. The electrostatic capacitance becomes larger than the line-to-line distribution capacitance formed between the signal patterns. Therefore, if no power source land is formed, interference between the signal patterns due to a variation in a distribution capacitance between the signal patterns, and therefore, a leakage of a signal current occurs by an inter-action of an electric field and a magnetic field, and the EMI noise is resultingly generated. However, the electrostatic capacitance by the power source land is larger than the line-to-line distribution capacitance in the present invention, and therefore, a signal current being leaked is completely grounded through the large electrostatic capacitance, and therefore, the EMI noise due to the leakage signal current can be effectively suppressed.

As to the ground land associated with the ground terminal of the connector, the same can perform the same or similar function as that of the ground land for the digital IC.

Furthermore, an electrostatic capacitance larger than the line-to-line distribution capacitance of the signal pattern is formed by the capacitance land which is formed in association with the other terminal of the connector, whereby a line-to-line characteristic impedance between the signal patterns is lowered, and therefore, an energy stored in the other terminal, that is, other signal pattern becomes small, and thus, the EMI noise due to the stored energy can be suppressed. More specifically, the signal pattern has an inductance component, and therefore, an energy is stored in the signal pattern due to a mismatching with respect to a small input impedance of the digital IC, for example, and the stored energy is radiated as the EMI noise. This is remarkable at a point where the signal pattern is folded or curved. By contrast, since the large electrostatic capacitance is formed by the capacitance land, as described above, the stored energy on the signal pattern becomes small, and therefore, the EMI noise due to the stored energy can be suppressed.

In accordance with the present invention, the EMI noise is very effectively suppressed by the ground land. More specifically, in accordance with the present invention, since the EMI noise component is suppressed from being generated on the printed circuit board, as different from the conventional one, the printed circuit board itself does not become to a radiating source of the EMI noise. Therefore, when the printed circuit board capable of preventing the EMI in accordance with the present invention is utilized, it becomes unnecessary to use the above described conventional shielding technique, specific connector and the like. Therefore, it is possible to save a large amount of money for the same.

In addition, if the large electrostatic capacitance is obtained by forming the power source land and/or the capacitance land, it is possible to omit a large number of bypass capacitors which were needed for constructing an actual circuitry on the conventional printed circuit board. If and when discrete capacitors are utilized as these bypass capacitors, a frequency characteristic in a high-frequency region is deteriorated due to the inductance of lead wires thereof, and therefore, such discrete capacitors are not effective with respect to the EMI noise existing in a wide frequency range of 30-1000 MHz. By contrast, it is not necessary to connect the electrostatic capacitance formed by the power source land and the capacitance land by a lead wire, and therefore, no deterioration occurs in a frequency characteristic, and therefore, such an electrostatic capacitance can effectively function as a bypass capacitor.

The objects and other objects, features, aspects and advantages of the present invention will become more apparent from the following detailed description of the embodiments of the present invention when taken in conjunction with accompanying drawings.

### BRIEF DESCRIPTION OF THE DRAWINGS

Fig. 1 is a pattern layout showing one example of a first electric conductive layer formed on an insulating base plate in accordance with an embodiment of the present invention.

Fig. 2 is a pattern layout showing one example of an insulation layer formed on a first electric conductive layer.

Fig. 3 is a pattern layout showing one example of a second electric conductive layer formed on an insulation layer.

Fig. 4A is a cross-section view showing vicinity of a hole for a ground terminal of a digital IC, and Fig. 4B is a partial cross-section view at a line IVB of Fig. 1 illustrating an insulation layer and respective electric conductive layers.

Fig. 5A is a cross-section view showing vicinity of a hole for a power source terminal of a digital IC, and Fig. 5B is a partial cross-section view at a line VB of Fig. 1 illustrating an insulation layer and respective electric conductive layers.

Fig. 6A is a partial cross-section view at a line VIA of Fig. 1 illustrating an insulation layer and respective electric conductive layers, and Fig. 6B is a partial cross-section view at a line VIB of Fig. 1.

Fig. 7 is a graph showing advantages of the present invention, wherein a line A shows a case where a printed circuit board having no second electric conductive layer is utilized and a line B shows a case where a printed circuit board in accordance with the embodiment shown by Fig. 1 - Fig. 6B.

### DETAIL DESCRIPTION OF THE PREFERRED EMBODIMENTS

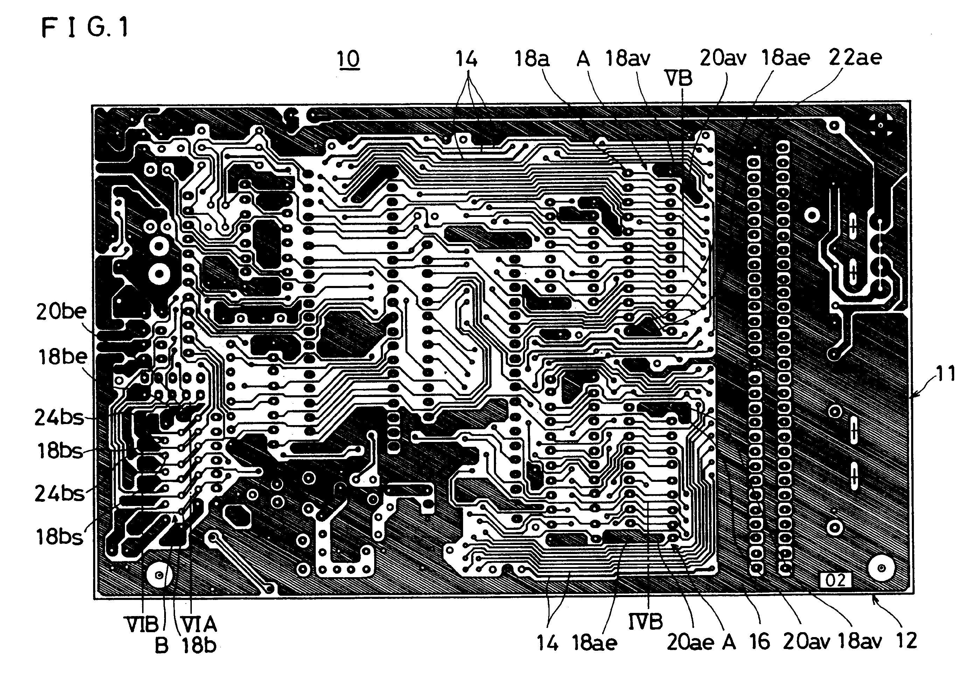

With reference to Fig. 1, a printed circuit board 10 capable of preventing electromagnetic interference of this embodiment includes an insulating base plate 12 made of a glass-epoxy, for example, on which a first electric conductive layer 11 which is shown by oblique lines (hatching lines) and made of a copper foil, for example. As similar a conventional printed circuit board, the first electric conductive layer 11 forms signal patterns 14 on which signals flow and a ground pattern 16.

An area shown by a reference character A is an area where a digital IC (not shown) such as a microcomputer, microprocessor or the like is to be mounted, and an area shown by a reference character B is an area where a connector (not shown) for connecting the printed circuit board 10 to equipments or printed circuit boards other than the printed circuit board 10 is to be mounted.

Paying attention to the areaA, holes 18a, 18a, ... for respective terminals (not shown) of a dual-in-line digital IC are formed. A hole 18ae is a hole for inserting a ground terminal of the digital IC, and a ground land 20ae having large area is formed in the vicinity of the hole 18ae. In addition, a hole 18av is a hole for inserting a terminal for power source Vcc of the digital IC, and a power source land 20av having large area is formed in the vicinity of the hole 18av.

Paying attention to the area B, holes for respective terminals (not shown) of the connector are formed. A hole 18be is a hole for inserting a ground terminal of the connector, and a ground land 20be having large area is formed in the vicinity of the hole 18be. In addition, holes 18bs are holes for inserting signal terminals other than the ground terminals, and capacitance lands 24bs each having large area are formed in the vicinity of the holes 18bs.

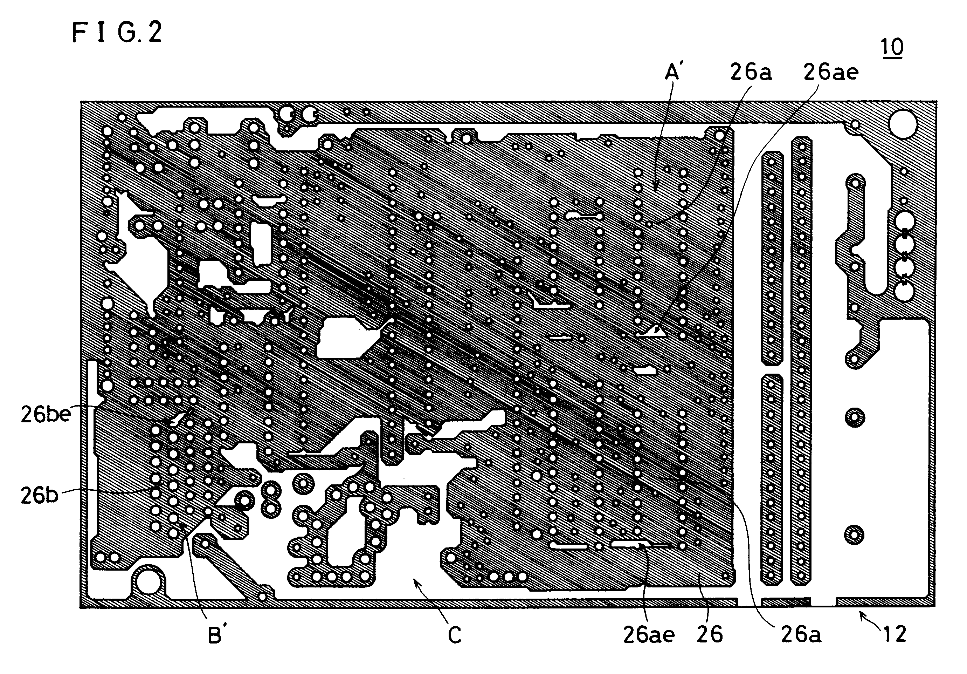

On such an insulating base plate 12, an insulation resin layer 26 shown by oblique lines (hatching lines) in Fig. 2 is formed so as to cover a portion of the first electric conductive layer 11, that is, the signal patterns 14 (Fig. 1) and ground patterns 16 (Fig. 1) on the insulating base plate 12. In an area A′ corresponding to the above described area A, a hole 26ae having substantially the same form as the ground land 20ae (Fig. 1) is formed correspondingly in position to the ground land 20ae. In a remaining portion of the area A′ including the above described power source land 20av, an insulation resin layer 26a is formed. In addition, in an area B′ corresponding to the above described area B, a hole 26be having substantially the same form as the ground land 20be (Fig. 1) is formed correspondingly in position thereto. An insulation resin layer 26b is formed in a remaining portion of the area B′ including a portion of the above described capacitance land 24bs.

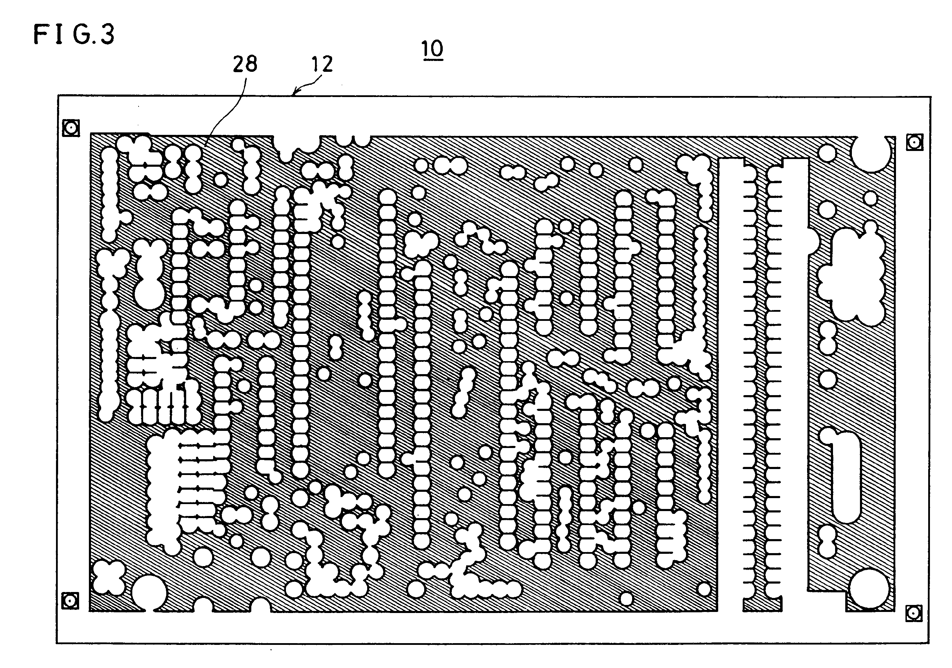

On the insulating base plate 12, a second electric conductive layer shown by oblique lines (hatching lines) in Fig. 3 is formed over the insulation resin layer 26 shown in Fig. 2. The second electric conductive layer 28 may be formed an arbitrary electric conductive material. Therefore, the second electric conductive layer 28 may be formed by a copper ink or paste as similar to co-pending Japanese Patent Laid-open No. 62-213192 (USP No. 4,801,489). As shown in Fig. 3, the second electric conductive layer 28 is formed on substantially the whole surface of the insulating base plate 12 so as to be connected to the ground pattern 16 on the insulating base plate 12 at portions as many as possible, for example, in area C shown in Fig. 2.

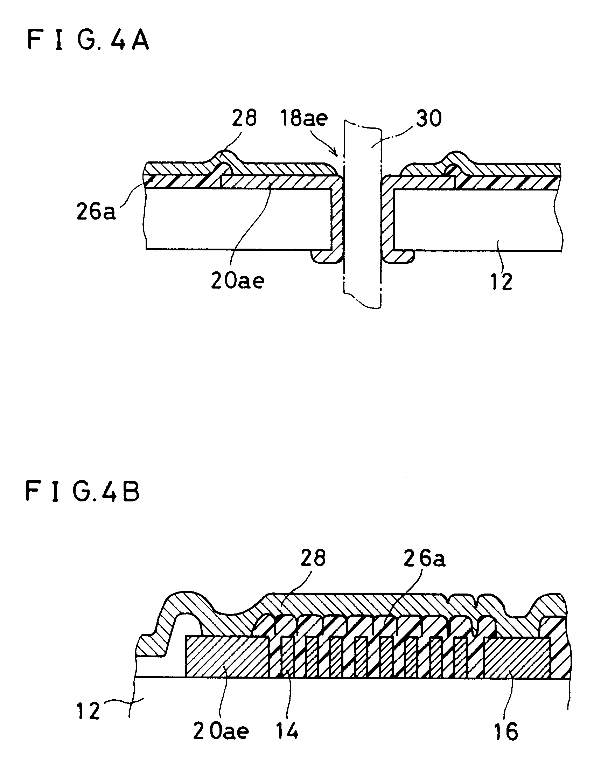

As shown in Fig. 4A and Fig. 4B, the ground land 20ae surrounding the hole 18ae for the ground terminal of the digital IC is directly surface-contacted with the second electric conductive layer through the hole 26ae (Fig. 2) of the insulation resin layer 26 having the same form as the ground land 20ae. Therefore, an inductance between the ground land 20ae and the second electric conductive layer 28 becomes very small, and therefore, a ground impedance of the ground land 20ae, that is, a ground terminal 30 of the digital IC is very small.

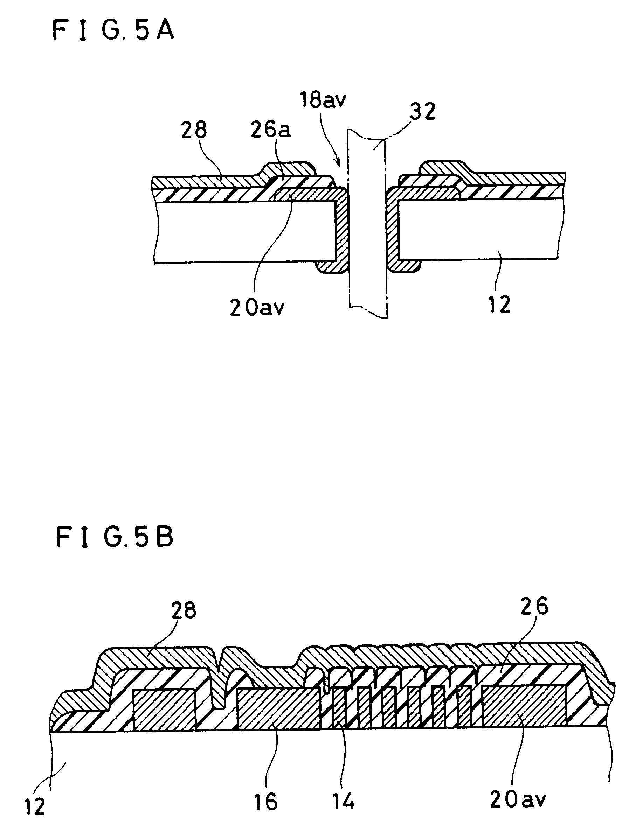

As shown in Fig. 5A and Fig. 5B, the power source land 20av in the vicinity of the hole 18av for the power source terminal of the digital IC is opposite to the second electric conductive layer 28 via the insulation resin layer 26a. Therefore, a very large electrostatic capacitance can be formed between the power source land 20av and the second electric conductive layer 28. Such an electrostatic capacitance becomes larger than a line-to-line distribution capacitance formed by signal patterns 14 shown in Fig. 1.

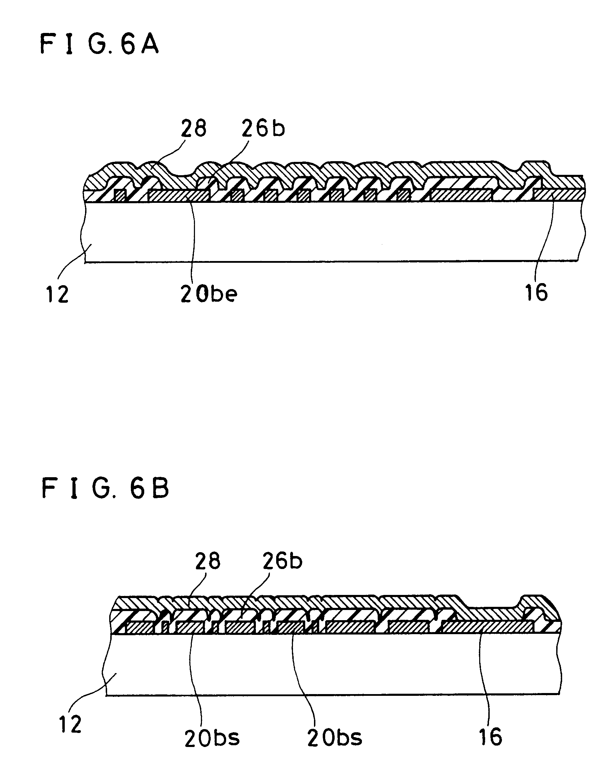

Similarly, as shown in Fig. 6A, the ground land 20be in the vicinity of the hole 18be (Fig. 1) for the ground terminal of the connector is directly surface-contacted with the second electric conductive layer 28 through the hole 26be (Fig. 2) of the insulation resin layer 26 having the same form as the ground land 20be. Therefore, an inductance between the ground land 20be and the second electric conductive layer 28 becomes very small, and a ground impedance of the ground land 20be, that is, the ground terminal (not shown) of the connector is very small. In addition, as shown in Fig. 6B, the capacitance lands 20bs in the vicinity of the holes 18bs (Fig. 1) for signal terminals of the connector are opposite to the second electric conductive layer 28 via the insulation resin layer 26. Therefore, a very large electrostatic capacitance is formed between respective one of the capacitance lands 20bs and the second electric conductive layer 28. The electrostatic capacitance becomes larger than a line-to-line distribution capacitance formed by the signal patterns 14 shown in Fig. 1.

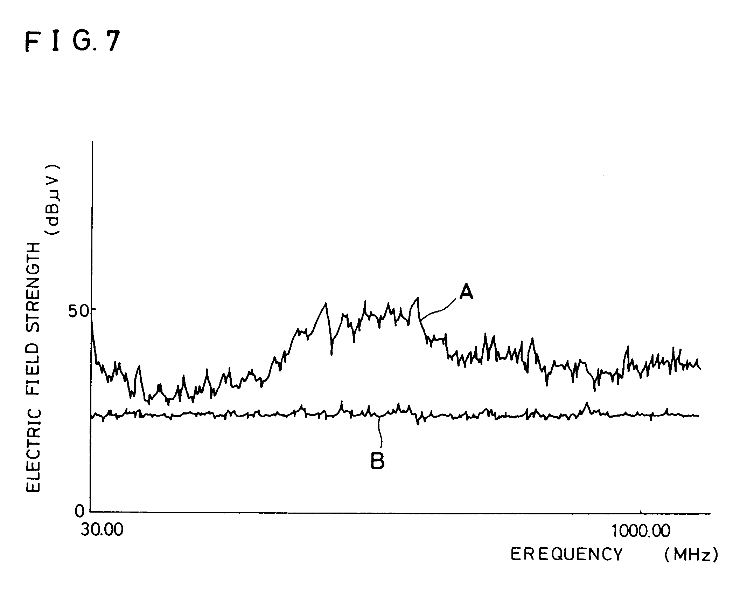

In accordance with the above described embodiment, as shown by a line B in Fig. 7, it is confirmed by the inventors that no EMI noise occurs in a frequency range of 30-1000 MHz. In addition, a line A in Fig. 7 shows an EMI noise level of a case where a former printed circuit board having no second electric conductive layer.

In addition, in the embodiment shown, lead wires of electronic components and terminals of a connector are inserted through the holes of the printed circuit board; however, it is needless to say that the present invention can be applied to a printed circuit board of a so-called surface-mounting type.

Although the present invention has been described and illustrated in detail, it is clearly understood that the same is by way of illustration and example only and is not to be taken by way of limitation, the scope of the present invention being limited only by the terms of the appended claims.

## Claims

1. A printed circuit board capable of preventing electromagnetic interference, comprising:
an insulating base plate (12);
a first electrically conductive layer formed (11) on said insulating base plate, said first conductive layer providing a signal pattern (14) and a ground pattern (16) for physical connection to terminals of a digital IC to be received on the board;
an insulation layer (26) formed on said insulating base plate so as to cover at least said signal pattern;
a second electrically conductive layer (28) formed on said insulation layer and electrically connected to said ground pattern, said second conductive layer being operative to suppress emission of EMI radiation at a frequency with a range of 30 - 1000 MHz; and
a ground land (20ae) formed to be in the vicinity of ground terminal (30) of said digital IC by said first conductive layer (11) and physically connected to said ground terminal, said ground land being directly surface-connected to said second conductive layer and sufficiently large as to reduce the ground impedance of said ground terminal of said digital IC at said frequency.

2. A printed circuit board in accordance with claim 1, further comprising a power source land (20av) formed in the vicinity of a power source terminal (32) for said digital IC by said first conductive layer (11) and connected to said power source terminal, said power source land (20av) being opposite to said second conductive layer, with said insulation layer therebetween, said power source land being sufficiently large that an electrostatic capacitance larger than a line-to-line distribution capacitance formed by said signal pattern is formed between said power source land and said second conductive layer at said frequency.

3. A printed circuit board in accordance with claim 1 or 2, configured to receive a connector, and including a further ground land (20be) formed in the vicinity of a ground terminal for the connector and connected to said ground terminal by said first electric conductive layer (11), said further ground land being directly surface-connected to said second electric conductive layer (28) so as to reduce the ground impedance of said ground terminal of said connector at said frequency.

4. A printed circuit board in accordance with claim 3, further comprising a capacitance land (24bs) formed to be in the vicinity of another terminal of said connector and connected thereto, said capacitance land (24bs) being opposite to said second conductive layer (28) with said insulation layer (26) therebetween said capacitance land (24bs) being sufficiently large and capacitively coupled to said second conductive layer that an electrostatic capacitance larger than a line-to-line distrubition capacitance formed by said signal pattern is formed between said capacitance land and said second conductive layer at said frequency.

5. A printed circuit board capable of preventing electromagnetic interference, comprising:
an insulating base plate (12);
a first electrically conductive layer (11) formed on said insulating base plate, said first conductive layer forming a signal pattern (14) and a ground pattern (16) for connection to a digital IC to be received on the board;
an insulation layer (26) formed on said insulating base plate so as to cover at least said signal pattern; a second electrically conductive layer (28) formed on said insulation layer and electrically connected to said ground pattern said second conductive layer being operative to suppress emission of EMI radiation from the board over a predetermined frequency range; and
**characterised by**
a power source land (20av) provided to be in the vicinity of a power source terminal (32) for the digital IC by said first conductive layer (11) and physically connected to said power source terminal, said power source land (20av) and said second conductive layer overlying one another so as to sandwich said insulation layer so that an electrostatic capacitance larger than a line-to-line distribution capacitance formed by said signal pattern, is formed between said power source land and said second conductive layer at a frequency in said range.

6. A printed circuit board in accordance with claim 5, configured to receive a connector, and including ground land (20be) formed in the vicinity of a ground terminal for the connector by said first conductive layer (11) and connected to said ground terminal, said ground land being directly surface-connected to said second conductive layer (28) so as to reduce the ground impedance of said ground terminal of said connector at said frequency.

7. A printed circuit board in accordance with claim 5 or 6, further comprising a capacitance land (24bs) formed to be in the vicinity of another terminal of said connector connected to the other terminal, said capacitance land (24bs) being opposite to said second conductive layer (28) with said insulation layer (26) therebetween, said capacitance land (24bs) being sufficiently large and capacitively coupled to said second conductive layer that an electrostatic capacitance larger than a line-to-line distribution capacitance formed by said pattern is formed between said capacitance land and said second conductive layer at said frequency.

8. A printed circuit board capable of preventing electromagnetic interference, comprising:
an insulating base plate (12) for receiving a connector;
a first electrically conductive layer (11) formed on said insulating base plate, said first electrically conductive layer forming a signal pattern (14) and a ground pattern (16);
an insulation layer (26) formed on said insulating base plate so as to cover at least said signal pattern; a second electrically conductive layer (28) formed on said insulation layer and electrically connected to said ground pattern, said second conductive layer being operative to suppress emission of EMI radiation from the board over a predetermined frequency range;
**characterised by**
a ground land (20be) formed to be in the vicinity of a ground terminal for the connector and to be physically connected to said ground terminal, said ground land being directly surface-connected to said second conductive layer (28) so as to reduce the ground impedance of said ground terminal of said connector; and
a capacitance land (24bs) formed in the vicinity of another terminal for said connector and physically connected thereto, said capacitance land being opposite to said second electric conductive layer (28) such as to sandwich said insulation layer to form therebetween an electrostatic capacitance larger than a line-to-line distribution capacitance formed by said signal pattern at a frequency in said range.

## Patentansprüche

1. Leiterplatte, die imstande ist, Störstrahlungen zu verhindern, enthaltend:
eine isolierende Grundplatte (12);
eine erste elektrisch leitende Schicht (11), die auf der isolierenden Grundplatte gebildet ist, wobei die erste leitende Schicht ein Signalmuster (14) und ein Erdmuster (16) für eine physische Verbindung mit Anschlüssen eines auf der Leiterplatte aufzunehmenden digitalen IC liefert;
eine Isolationsschicht (26), die auf der isolierenden Grundplatte gebildet ist, so daß sie wenigstens das Signalmuster bedeckt;
eine zweite elektrisch leitende Schicht (28), die auf der Isolationsschicht gebildet und elektrisch mit dem Erdmuster verbunden ist, wobei die zweite leitende Schicht wirksam ist, um Emissionen von EMI-Strahlung bei einer Frequenz mit einem Bereich von 30 - 1000 MHz zu unterdrücken; und
eine Erdkontaktfläche (20ae), die durch die erste leitende Schicht (11) gebildet wird, so daß sie in der Umgebung des Erdanschlusses (30) des digitalen IC liegt, und die physisch mit dem Erdanschluß verbunden ist, wobei die Erdkontaktfläche direkt mit der zweiten leitenden Schicht oberflächenverbunden ist und groß genug ist, um den Erdwiderstand des Erdanschlusses des digitalen IC bei der Frequenz zu verringern.

2. Leiterplatte nach Anspruch 1, die weiterhin eine Stromversorgungs-Kontaktfläche (20av) aufweist, die durch die erste leitende Schicht (11) in der Umgebung eines Stromversorgungsanschlusses (32) für den digitalen IC gebildet wird und die mit dem Stromversorgungsanschluß verbunden ist, wobei die Stromversorgungs-Kontaktfläche (20av) gegenüber der zweiten leitenden Schicht liegt, mit der Isolationsschicht dazwischen, und wobei die Stromversorgungs-Kontaktfläche groß genug ist, daß zwischen der Stromversorgungs-Kontaktfläche und der zweiten leitenden Schicht bei der Frequenz eine elektrostatische Kapazität gebildet wird, die größer als eine Leitungsverteilungs-Kapazität ist, die durch das Signalmuster gebildet wird.

3. Leiterplatte nach Anspruch 1 oder 2, die gestaltet ist, um einen Steckverbinder aufzunehmen, und die eine weitere Erdkontaktfläche (20be) enthält, die in der Umgebung eines Erdanschlusses für den Steckverbinder gebildet ist und die durch die erste elektrisch leitende Schicht (11) mit dem Erdanschluß verbunden ist, wobei die weitere Erdkontaktfläche direkt mit der zweiten elektrisch leitenden Schicht (28) oberflächenverbunden ist, um den Erdwiderstand des Erdanschlusses des Steckverbinders bei der Frequenz zu verringern.

4. Leiterplatte nach Anspruch 3, die weiterhin eine Kapazitäts-Kontaktfläche (24bs) aufweist, die so gebildet ist, daß sie in der Umgebung eines anderen Anschlusses des Steckverbinders liegt und damit verbunden ist, wobei die Kapazitäts-Kontaktfläche (24bs) gegenüber der zweiten leitenden Schicht (28) liegt, mit der Isolationsschicht (26) dazwischen, und wobei die Kapazitäts-Kontaktfläche (24bs) genügend groß und kapazitiv mit der zweiten leitenden Schicht verbunden ist, daß zwischen der Kapazitäts-Kontaktfläche und der zweiten leitenden Schicht bei der Frequenz eine elektrostatische Kapazität gebildet wird, die größer als eine Leitungsverteilungs-Kapazität ist, die durch das Signalmuster gebildet wird.

5. Leiterplatte, die imstande ist, Störstrahlungen zu verhindern, enthaltend:
eine isolierende Grundplatte (12);
eine erste elektrisch leitende Schicht (11), die auf der isolierenden Grundplatte gebildet ist, wobei die erste leitende Schicht ein Signalmuster (14) und ein Erdmuster (16) für eine Verbindung mit einem auf der Leiterplatte aufzunehmenden digitalen IC bildet;
eine Isolationsschicht (26), die auf der isolierenden Grundplatte gebildet ist, so daß sie wenigstens das Signalmuster bedeckt;
eine zweite elektrisch leitende Schicht (28), die auf der Isolationsschicht gebildet und elektrisch mit dem Erdmuster verbunden ist, wobei die zweite leitende Schicht wirksam ist, um Emissionen von EMI-Strahlung von der Leiterplatte über einem vorbestimmten Frequenzbereich zu unterdrücken; und
gekennzeichnet durch
eine Stromversorgungs-Kontaktfläche (20av), die durch die erste leitende Schicht (11) gebildet wird, so daß sie in der Umgebung eines Stromversorgungsanschlusses (32) für den digitalen IC liegt, und die physisch mit dem Stromversorgungsanschluß verbunden ist, wobei die Stromversorgungs-Kontaktfläche (20av) und die zweite leitende Schicht übereinanderliegen, um die Isolationsschicht zwischen sich einzuschließen, so daß zwischen der Stromversorgungs-Kontaktfläche und der zweiten leitenden Schicht bei einer Frequenz in dem Bereich eine elektrostatische Kapazität gebildet wird, die größer als eine Leitungsverteilungs-Kapazität ist, die durch das Signalmuster gebildet wird.

6. Leiterplatte nach Anspruch 5, die gestaltet ist, um einen Steckverbinder aufzunehmen, und die eine Erdkontaktfläche (20be) enthält, die durch die erste leitende Schicht (11) in der Umgebung eines Erdanschlusses für den Steckverbinder gebildet wird und die mit dem Erdanschluß verbunden ist, wobei die Erdkontaktfläche direkt mit der zweiten leitenden Schicht (28) oberflächenverbunden ist, um den Erdwiderstand des Erdanschlusses des Steckverbinders bei der Frequenz zu verringern.

7. Leiterplatte nach Anspruch 5 oder 6, die weiterhin eine Kapazitäts-Kontaktfläche (24bs) aufweist, die so gebildet ist, daß sie in der Umgebung eines anderen Anschlusses des Steckverbinders liegt und mit dem anderen Anschluß verbunden ist, wobei die Kapazitäts-Kontaktfläche (24bs) gegenüber der zweiten leitenden Schicht (28) liegt, mit der Isolationsschicht (26) dazwischen, und wobei die Kapazitäts-Kontaktfläche (24bs) genügend groß und kapazitiv mit der zweiten leitenden Schicht verbunden ist, daß zwischen der Kapazitäts-Kontaktfläche und der zweiten leitenden Schicht bei der Frequenz eine elektrostatische Kapazität gebildet wird, die größer als eine Leitungsverteilungs-Kapazität ist, die durch das Muster gebildet wird.

8. Leiterplatte, die imstande ist, Störstrahlungen zu verhindern, enthaltend:
eine isolierende Grundplatte (12) zur Aufnahme eines Steckverbinders;
eine erste elektrisch leitende Schicht (11), die auf der isolierenden Grundplatte gebildet ist, wobei die erste elektrisch leitende Schicht ein Signalmuster (14) und ein Erdmuster (16) bildet;
eine Isolationsschicht (26), die auf der isolierenden Grundplatte gebildet ist, so daß sie wenigstens das Signalmuster bedeckt;
eine zweite elektrisch leitende Schicht (28), die auf der Isolationsschicht gebildet und elektrisch mit dem Erdmuster verbunden ist, wobei die zweite leitende Schicht wirksam ist, um Emissionen von EMI-Strahlung von der Leiterplatte über einem vorbestimmten Frequenzbereich zu unterdrücken;
gekennzeichnet durch
eine Erdkontaktfläche (20be), die so gebildet ist, daß sie in der Umgebung eines Erdanschlusses für den Steckverbinder liegt und physisch mit dem Erdanschluß verbunden ist, wobei die Erdkontaktfläche direkt mit der zweiten leitenden Schicht (28) oberflächenverbunden ist, um den Erdwiderstand des Erdanschlusses des Steckverbinders zu verringern; und
eine Kapazitäts-Kontaktfläche (24bs), die in der Umgebung eines anderen Anschlusses für den Steckverbinder gebildet und physisch damit verbunden ist, wobei die Kapazitäts-Kontaktfläche gegenüber der zweiten elektrisch leitenden Schicht (28) liegt, so daß die Isolationsschicht dazwischen eingeschlossen wird, um dazwischen eine elektrostatische Kapazität zu bilden, die größer als eine Leitungsverteilungs-Kapazität ist, die durch das Signalmuster bei einer Frequenz in dem Bereich gebildet wird.

## Revendications

1. Carte à circuit imprimé capable d'empêcher l'interférence électromagnétique, comprenant:
une embase isolante (12);
une première couche électriquement conductrice (11) formée sur ladite embase isolante, ladite première couche conductrice procurant un motif de signaux (14) et un motif de masse (16) destinées à la connexion physique des bornes d'un CI numérique devant être reçu sur la carte;
une couche isolante (26) formée sur ladite embase isolante de façon à couvrir au moins ledit motif de signaux;
une seconde couche électriquement conductrice (28) formée sur ladite couche isolante et électriquement connectée audit motif de masse, ladite seconde couche conductrice ayant pour fonction de supprimer les radiations IEM à une fréquence comprise entre 30 et 1000 MHz; et
une plage de masse (20ae) formée au voisinage de la borne de masse (30) dudit CI numérique par ladite première couche conductrice (11) et connectée physiquement à ladite borne de masse, ladite plage de masse étant directement connectée par la surface à ladite seconde couche conductrice et suffisamment grande pour réduire l'impédance de masse de ladite borne de masse dudit CI numérique, à ladite fréquence.

2. Carte à circuit imprimé selon la revendication 1, comprenant en outre une plage de source d'énergie (20av) formée au voisinage d'une borne de source d'énergie (32) et destinée audit CI numérique par ladite première couche conductrice (11) et connectée à ladite borne de source d'énergie, ladite plage de source d'énergie (20av) étant opposée à ladite seconde couche conductrice, ladite couche isolante étant entre les deux, ladite plage de source d'énergie étant suffisamment grande pour qu'une capacité électrostatique plus grande qu'une capacité de répartition entre rubans formée par ledit motif de signaux, soit formée entre ladite plage de source d'énergie et ladite seconde couche conductrice, à ladite fréquence.

3. Carte à circuit imprimé selon la revendication 1 ou 2, configurée pour recevoir un connecteur et comprenant une plage de masse supplémentaire (20be) formée au voisinage d'une borne de masse destinée au connecteur et connectée à ladite borne de masse par ladite première couche électriquement conductrice (11), ladite plage de masse supplémentaire étant directement connectée par la surface à ladite seconde couche électriquement conductrice (28) de façon à réduire l'impédance de masse de ladite borne de masse dudit connecteur, à ladite fréquence.

4. Carte à circuit imprimé selon la revendication 3, comprenant en outre une plage de capacité (24bs) formée pour être au voisinage d'une autre borne dudit connecteur et lui étant connectée, ladite plage de capacité (24bs) étant opposée à ladite seconde couche conductrice (28), ladite couche isolante (26) étant entre les deux, ladite plage de capacité (24bs) étant suffisamment grande et étant couplée de façon capacitive à ladite seconde couche conductrice pour qu'une capacité électrostatique plus grande qu'une capacité de répartition entre rubans formée par ledit motif de signaux, soit formée entre ladite plage de capacité et ladite seconde couche conductrice, à ladite fréquence.

5. Carte à circuit imprimé capable d'empêcher l'interférence électromagnétique, comprenant:
une embase isolante (12);
une première couche électriquement conductrice (11) formée sur ladite embase isolante, ladite première couche formant un motif de signaux (14) et un motif de masse (16) destinées à la connexion d'un CI numérique devant être reçue sur la carte;
une couche isolante (26) formée sur ladite embase isolante de façon à couvrir au moins ledit motif de signaux;
une seconde couche électriquement conductrice (28) formée sur ladite couche isolante et électriquement connectée audit motif de masse, ladite seconde couche conductrice ayant pour fonction de supprimer les radiations IEM provenant de la carte, dans une bande de fréquences prédéterminée; et
caractérisée par
une plage de source d'énergie (20av) prévue pour être au voisinage d'une borne de source d'énergie (32) et destinée au CI numérique par ladite première couche conductrice (11) et connectée physiquement à ladite borne de source d'énergie, ladite plage de source d'énergie (20av) et ladite seconde couche conductrice se superposant l'une sur l'autre de façon à prendre en sandwich ladite couche isolante afin qu'une capacité électrostatique plus grande qu'une capacité de répartition entre rubans formée par ledit motif de signaux, soit formée entre ladite plage de source d'énergie et ladite seconde couche conductrice, à une fréquence de ladite bande.

6. Carte à circuit imprimé selon la revendication 5, configurée pour recevoir un connecteur et comprenant une plage de masse (20be) formée au voisinage d'une borne de masse destinée au connecteur par ladite première couche conductrice (11) et connectée à ladite borne de masse, ladite plage de masse étant directement connectée par la surface à ladite seconde couche conductrice (28) de façon à réduire l'impédance de masse de ladite borne de masse dudit connecteur, à ladite fréquence.

7. Carte à circuit imprimé selon la revendication 5 ou 6, comprenant en outre une plage de capacité (24bs) formée pour être au voisinage d'une autre borne dudit connecteur et lui étant connectée, ladite plage de capacité (24bs) étant opposée à ladite seconde couche conductrice (28), ladite couche isolante (26) étant entre les deux, ladite plage de capacité (24bs) étant suffisamment grande et étant couplée de façon capacitive à ladite seconde couche conductrice pour qu'une capacité électrostatique plus grande qu'une capacité de répartition entre rubans formée par ledit motif, soit formée entre ladite plage de capacité et ladite seconde couche conductrice, à ladite fréquence.

8. Carte à circuit imprimé capable d'empêcher l'interférence électromagnétique, comprenant:
une embase isolante (12) destinée à recevoir un connecteur;
une première couche électriquement conductrice (11) formée sur ladite embase isolante, ladite première couche électriquement conductrice formant un motif de signaux (14) et un motif de masse (16);
une couche isolante (26) formée sur ladite embase isolante de façon à couvrir au moins ledit motif de signaux;
une seconde couche électriquement conductrice (28) formée sur ladite couche isolante et électriquement connectée audit motif de masse, ladite seconde couche conductrice ayant pour fonction de supprimer les radiations IEM provenant de la carte, dans une bande de fréquences prédéterminée; et
caractérisée par
une plage de masse (20av) prévue pour être au voisinage d'une borne de masse et destinée au connecteur, et connectée physiquement à ladite borne de masse, ladite plage de masse étant directement connectée par la surface à ladite seconde couche conductrice (28) de façon à réduire l'impédance de masse de ladite borne de masse dudit connecteur; et
une plage de capacité (24bs) formée au voisinage d'une autre borne dudit connecteur et lui étant physiquement connectée, ladite plage de capacité étant opposée à ladite seconde couche physiquement conductrice (28) de façon à prendre en sandwich ladite couche isolante afin de former entre les deux une capacité électrostatique plus grande qu'une capacité de répartition entre rubans formée par ledit motif de signaux, à une fréquence de ladite bande.
